# EUROPEAN PATENT APPLICATION

(11) **EP 2 416 379 A1**
(43) Date of publication of application: **08.02.2012**
(21) Application number: 10761335.8
(22) Date of filing: 19.03.2010
(51) Int. Cl.: H01L 31/042, B32B 27/20, B32B 27/40

(54) **PROTECTIVE SHEET FOR THE REAR SURFACE OF A SOLAR CELL MODULE, AND SOLAR CELL MODULE PROVIDED THEREWITH**

(30) Priority: 30.03.2009 JP 2009081037
(71) Applicant: LINTEC Corporation, Tokyo 173-0001 (JP)
(72) Inventor: TAMADA, Takashi, Tokyo 173-0001 (JP)
(74) Representative: Jansen, Cornelis Marinus
(86) International application number: PCT/JP2010/001975
(87) International publication number: WO 2010/116627

(57) **Abstract**

A protective sheet for the back surface of a solar cell module prepared by laminating a thermal adhesive sheet to at least one surface of a base sheet with a urethane-based adhesive layer disposed therebetween, wherein the thermal adhesive sheet contains a pigment and the urethane-based adhesive layer contains a silane coupling agent. The pigment is preferably an inorganic pigment or a carbon black.

## Description

### TECHNICAL FIELD

The present invention relates to a protective sheet for the back surface of a solar cell module, and a solar cell module provided with the protective sheet for the back surface of a solar cell module.
Priority is claimed on Japanese Patent Application No. 2009-081037, filed March 30, 2009, the content of which is incorporated herein by reference.

### BACKGROUND ART

Solar cell modules, which are devices for converting the energy from sunlight into electrical energy, are attracting much attention as systems that are capable of generating electricity without discharging carbon dioxide.

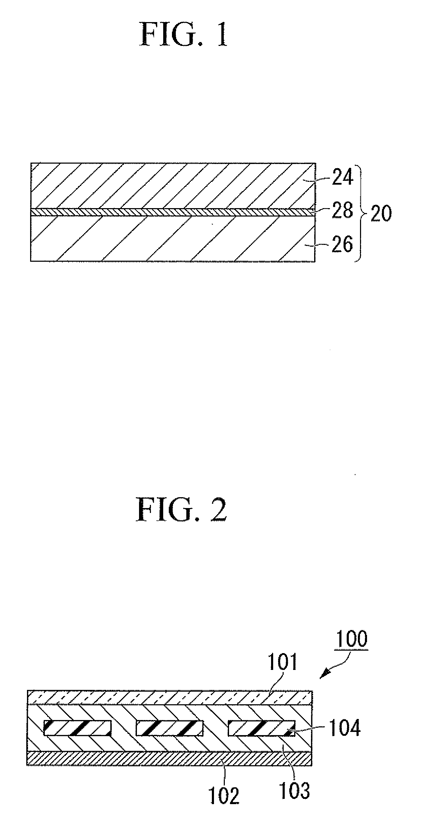

FIG. 2 is a schematic cross-sectional view illustrating one example of a typical solar cell module.
This type of solar cell module 100 includes basically solar cell 104 composed of crystalline silicon or amorphous silicon or the like, an encapsulant (filler layer) 103 formed from an electrical insulator that encapsulates the solar cell 104, a surface protective sheet (front sheet) 101 that is laminated to the front surface of the encapsulant 103, and a back protective sheet (back sheet) 102 that is laminated to the back surface of the encapsulant 103. The base material of the front sheet 101 may be a glass sheet.

In order to impart the solar cell module with the levels of weather resistance and durability necessary to withstand use for long periods in outdoor and indoor environments, the solar cell 104 and the encapsulant 103 must be protected from heavy rain, moisture, dust and mechanical impacts and the like, and must be maintained in a sealed state that shields the interior of the solar cell module from the external atmosphere. Accordingly, the back protective sheet 102 for the solar cell module requires superior levels of weather resistance, durability, and resistance to moisture and heat.

Conventionally, polyester films such as polyethylene terephthalate, which exhibit excellent electrical insulation properties, have been used in the development of protective sheets for the back surface of solar cell modules. In order to improve the inferior weather resistance that represents one of the drawbacks of using polyester films, a variety of back protective sheets have been disclosed, including films that contain an added ultraviolet absorber (see Patent Document 1), films containing a specified amount of a cyclic oligomer within the polyester (see Patent Documents 2 and 3), and films in which the molecular weight of the polyester is specified (see Patent Document 4). Further, in order to improve the relatively poor adhesion between the film and the ethylene-vinyl acetate copolymer (EVA) that is typically used as the encapsulant 103, back protective sheets have been disclosed in which a thermal adhesive sheet composed mainly of EVA is bonded to the above-mentioned film using an adhesive, wherein a urethane-based adhesive is used as the adhesive (see Patent Documents 5 to 7).

### PRIOR ART DOCUMENTS

### PATENT DOCUMENTS

[Patent Document 1]
   Japanese Unexamined Patent Application, First Publication No. 2001-111073
[Patent Document 2]
   Japanese Unexamined Patent Application, First Publication No. 2002-100788
[Patent Document 3]
   Japanese Unexamined Patent Application, First Publication No. 2002-134771
[Patent Document 4]
   Japanese Unexamined Patent Application, First Publication No. 2002-26354
[Patent Document 5]
   Japanese Unexamined Patent Application, First Publication No. 2008-85294
[Patent Document 6]
   Japanese Unexamined Patent Application, First Publication No. 2007-320218
[Patent Document 7]
   Japanese Unexamined Patent Application, First Publication No. 2008-4691

### DISCLOSURE OF INVENTION

### PROBLEMS TO BE SOLVED BY THE INVENTION

However, in the protective sheets for the back surfaces of solar cell modules disclosed in the conventional technology, although the base film of polyethylene terephthalate or the like is bonded to the encapsulant 103 via a urethane-based adhesive and a thermal adhesive sheet, the adhesion between the urethane-based adhesive and the thermal adhesive sheet and the resulting moisture and heat resistance tend to be inadequate, and if the solar cell module is used outdoors for a long period, then peeling of the base film can cause electrical leakage or corrosion of the electrical circuits inside the solar cell module.

The present invention takes the above circumstances into consideration, with an object of providing a protective sheet for the back surface of a solar cell module that exhibits excellent weather resistance, durability, and moisture and heat resistance, exhibits particularly superior adhesion to encapsulants, and enables the solar cell to be used in a stable manner for long periods, as well as providing a solar cell module that includes the protective sheet for the back surface of a solar cell module.

### MEANS TO SOLVE THE PROBLEMS

As a result of intensive research aimed at addressing the above problems and achieving the above object, the inventors of the present invention were able to complete the present invention. In other words, the present invention relates to a protective sheet for the back surface of a solar cell module that is prepared by laminating a thermal adhesive sheet to at least one surface of a base sheet with a urethane-based adhesive layer disposed therebetween, wherein the thermal adhesive sheet contains a pigment, and the urethane-based adhesive layer contains a silane coupling agent.

Further, the present invention also relates to the above protective sheet for the back surface of a solar cell module, wherein the pigment contained within the thermal adhesive sheet is an inorganic pigment or a carbon black. Moreover, the present invention also relates to a solar cell module that includes the above protective sheet for the back surface of a solar cell module.

### EFFECT OF THE INVENTION

In the present invention, by laminating a thermal adhesive sheet containing a pigment to a base sheet with a urethane-based adhesive layer containing a silane coupling agent disposed therebetween, the base sheet and the thermal adhesive sheet can be bonded together with superior adhesiveness, yielding a solar cell module back protective sheet that exhibits extremely superior moisture and heat resistance. Accordingly, a solar cell module back protective sheet can be provided that exhibits excellent barrier properties as a back protective sheet, and is capable of preventing electrical leakage or corrosion of the electrical circuits inside the solar cell module. By using this sheet as the protective sheet for the back surface of a solar cell module, the resulting solar cell module can be used in a stable manner for long periods.

### BRIEF DESCRIPTION OF THE DRAWINGS

FIG. 1 is a schematic cross-sectional view illustrating one example of an embodiment of a protective sheet for the back surface of a solar cell module according to the present invention.
FIG. 2 is a schematic cross-sectional view illustrating one example of a typical solar cell module.

### BEST MODE FOR CARRYING OUT THE INVENTION

Embodiments of the protective sheet for the back surface of a solar cell module according to the present invention are described below.
Although these embodiments provide specific descriptions to facilitate comprehension of the effect of the present invention, unless specifically stated otherwise, they in no way limit the scope of the present invention.

FIG. 1 is a schematic cross-sectional view illustrating one example of an embodiment of a protective sheet for the back surface of a solar cell module according to the present invention.
The solar cell module back protective sheet 20 of this embodiment has a laminated structure prepared by laminating a thermal adhesive sheet 26 to a base sheet 24 with a urethane-based adhesive layer 28 disposed therebetween.

In the solar cell module back protective sheet 20 of the present invention, the urethane-based adhesive layer 28 can be formed using a urethane-based adhesive containing a polyol compound, an isocyanate compound and a silane coupling agent.

In the present invention, there are no particular limitations on the molecular weight or structure of the polyol compound incorporated within the urethane-based adhesive, provided it is a compound that contains two or more hydroxyl groups. Specific examples of the polyol compound include low-molecular weight polyhydric alcohols, polyetherpolyols, polyesterpolyols, other polyols, and mixtures of the above polyols.

Specific examples of the low-molecular weight polyhydric alcohols include low-molecular weight polyols such as ethylene glycol, diethylene glycol, propylene glycol, dipropylene glycol, 1,3-butanediol, 1,4-butanediol, pentanediol, 3-methyl-1,5-pentanediol, neopentyl glycol, hexanediol, cyclohexanedimethanol, glycerol, 1,1,1-trimethylolpropane, 1,2,5-hexanetriol and pentaerythritol, and sugars such as sorbitol.

Specific examples of the polyetherpolyols include polyethylene glycol, polypropylene glycol, polypropylene triol, ethylene oxide/propylene oxide copolymers, poly(tetramethylene ether) glycol, and sorbitol-based polyols.

Examples of the polyesterpolyols include condensates (condensed polyesterpolyols) of an above-mentioned low-molecular weight polyhydric alcohol and/or an aromatic diol, and a polybasic carboxylic acid, as well as lactone-based polyols and polyesterpolyols having a bisphenol skeleton.
Specific examples of the polybasic carboxylic acids used in forming the above-mentioned condensed polyesterpolyols include glutaric acid, adipic acid, azelaic acid, pimelic acid, suberic acid, sebacic acid, terephthalic acid, isophthalic acid, dimer acid, other low-molecular weight carboxylic acids, oligomer acids, castor oil, and hydroxycarboxylic acids such as the reaction product of castor oil and ethylene glycol.
Further, specific examples of the above-mentioned lactone-based polyols include ring-opening polymers of propiolactone and valerolactone and the like.
Furthermore, examples of the polyesterpolyols having a bisphenol skeleton include condensed polyesterpolyols obtained by replacing the low-molecular weight polyhydric alcohol mentioned above with a diol having a bisphenol skeleton, or using a diol having a bisphenol skeleton in combination with the low-molecular weight polyhydric alcohol. Specific examples include polyesterpolyols obtained from bisphenol A and castor oil, and polyesterpolyols obtained from bisphenol A, castor oil, ethylene glycol and propylene glycol.
Specific examples of other polyols include polycarbonate diols, acrylic polyols, polybutadiene polyols, and polymer polyols having carbon-carbon bonds in the main chain structure such as hydrogenated polybutadiene polyols.
Of these polyol compounds, the use of polyesterpolyols, polyetherpolyols, polycarbonate diols and acrylic polyols, or polyester urethane polyols, polyether urethane polyols, polycarbonate urethane diols and acrylic urethane polyols that have undergone chain extension using a difunctional or higher isocyanate are particularly preferred for reasons of heat resistance and stability.

In the present invention, there are no particular limitations on the isocyanate compound incorporated within the urethane-based adhesive, provided it is a compound containing one or more isocyanate groups within the molecule, although the use of polyisocyanate compounds containing two or more isocyanate groups in the molecule is preferred. Specific examples of polyisocyanate compounds that may be used include aromatic polyisocyanates such as 2,4-tolylene diisocyanate, 2,6-tolylene diisocyanate, 4,4'-diphenylmethane diisocyanate, 1,4-phenylene diisocyanate, xylylene diisocyanate, tetramethylxylylene diisocyanate, tolidine diisocyanate, 1,5-naphthalene diisocyanate and triphenylmethane triisocyanate, aliphatic diisocyanates such as hexamethylene diisocyanate, trimethylhexamethylene diisocyanate, lysine diisocyanate and norbornane diisocyanate methyl, and alicyclic polyisocyanates such as trans-cyclohexane-1,4-diisocyanate, isophorone diisocyanate and bis(isocyanatomethyl)cyclohexane. Further, modified forms of these isocyanates may also be used, including isocyanurate-type or urethane-type trifunctional or higher polyfunctional isocyanurate compounds.
Of the above isocyanate compounds, xylylene diisocyanate, tetramethylxylylene diisocyanate, hexamethylene diisocyanate, trimethylhexamethylene diisocyanate and isophorone diisocyanate exhibit superior weather resistance, and are consequently preferred.
The isocyanate compound incorporated within the urethane-based adhesive used for forming the urethane-based adhesive layer 28 in the present invention may be a single compound or a combination of two or more compounds, and the total amount of the isocyanate compound used is preferably within a range from 5 to 40 parts by weight, more preferably from 10 to 30 parts by weight, and still more preferably from 10 to 20 parts by weight, per 100 parts by weight of the polyol incorporated within the urethane-based adhesive.

In the present invention, there are no particular limitations on the silane coupling agent incorporated within the urethane-based adhesive, and any conventional silane coupling agent may be used, including aminosilanes, mercaptosilanes, vinylsilanes, epoxysilanes, methacrylsilanes, isocyanatosilanes, ketimine silanes and alkoxysilanes. Among these silanes, 3-glycidoxypropyltrimethoxysilane, phenyltrimethoxysilane, tetraethoxysilane, 3-acetoxypropyltrimethoxysilane and 3-aminopropyltrimethoxysilane are preferred, as they yield improved adhesion of the urethane-based adhesive to the thermal adhesive sheet.
The silane coupling agent incorporated within the urethane-based adhesive used for forming the urethane-based adhesive layer of the present invention may be a single compound or a combination of two or more compounds, and the total amount of the silane coupling agent used is preferably within a range from 0.01 to 30 parts by weight, more preferably from 0.05 to 10 parts by weight, and still more preferably from 0.1 to 3 parts by weight, per 100 parts by weight of the polyol incorporated within the urethane-based adhesive.

In the present invention, besides the polyol compound, the isocyanate compound and the silane coupling agent described above, the urethane-based adhesive may also contain additives such as antioxidants, ultraviolet absorbers, hydrolysis inhibitors, thickeners, plasticizers and fillers, which may be added according to need. Of these additives, a carbodiimide compound or an oxazoline compound is preferably added for the purpose of inhibiting hydrolysis of the ester linkages. Further, the viscosity of the urethane-based adhesive may be altered by adding a solvent to improve the operating efficiency during application of the adhesive and layer formation. The solvent used may be any solvent that is inactive relative to the isocyanate, and specific examples include ester-based solvents such as ethyl acetate, ketone-based solvents such as methyl ethyl ketone, and aromatic hydrocarbon solvents such as toluene and xylene.

In the present invention, the urethane-based adhesive layer 28 can be formed by applying the above-mentioned urethane-based adhesive to the base sheet 24, and then performing drying and/or heating as required.
There are no particular limitations on the method used for applying the urethane-based adhesive to the base sheet 24. Any conventional method may be used, including knife coating, roll coating, bar coating, blade coating, die coating and gravure coating methods.
The thickness of the urethane-based adhesive layer 28 is preferably within a range from 1 µm to 50 µm, and more preferably from 3 µm to 30 µm.

In the solar cell module back protective sheet 20 of the present invention, there are no particular limitations on the thermal adhesive sheet 26, provided it is a resin sheet having thermal adhesiveness that also includes a pigment. In this description, the expression "thermal adhesiveness" describes a property wherein the sheet exhibits adhesiveness when subjected to a heat treatment. The temperature of the heat treatment is typically within a range from 50 to 200°C, and is preferably within a range from 85 to 180°C.

In the present invention, although there are no particular limitations on the pigment incorporated within the thermal adhesive sheet 26, from the viewpoint of improving the adhesion by increasing the affinity with the silane coupling agent contained in the urethane-based adhesive layer 28, an inorganic pigment or a carbon black is preferred, and specific examples of appropriate pigments include white pigments such as calcium carbonate, titanium oxide, silica, zinc oxide, lead carbonate and barium sulfate, black pigments such as carbon black (channel or furnace) and black iron oxide, blue pigments such as ultramarine and iron blue, red pigments such as red iron oxide, cadmium red and molybdenum orange, and metal powder pigments that impart a metallic luster. Of these, titanium oxide and carbon black are preferred. Moreover, these pigments are preferably coated or surface-treated with an organosilicon compound or the like, and pigments that have been provided with surface polar groups such as hydroxyl groups and alkoxyl groups by surface treatment can be used particularly favorably.

In the present invention, there are no particular limitations on the resin that constitutes the thermal adhesive sheet 26, provided it includes the above-mentioned pigment in a dispersed state therein, and specific examples of the resin include acrylic urethane resins, ethylene-vinyl acetate copolymers (EVA), polyvinyl butyral (PVB), ethylene-methacrylic acid copolymers, ionomer resins prepared by cross-linking molecules of an ethylene-methacrylic acid copolymer with metallic ions, and resins composed of polymers containing a polyolefin as the major component. Among these resins, EVA and PVB are preferred, and resins containing EVA as the main component are particularly desirable. The encapsulant 103 is generally a resin formed from EVA, and in such cases, using a thermal adhesive sheet 26 formed from a resin sheet composed of a polymer that contains EVA as the main component enables the compatibility and adhesion of the encapsulant 103 and the thermal adhesive sheet 26 to be improved.

The thermal adhesive sheet 26 can be formed using a method in which 0.5 to 30 parts by weight, and preferably 1 to 10 parts by weight, of the pigment that is to be incorporated within the thermal adhesive sheet 26 is kneaded into 100 parts by weight of the resin that constitutes the thermal adhesive sheet 26, and the resulting mixture is then subjected to melt extrusion using a T-die method or an inflation method. The thickness of the thermal adhesive sheet 26 may be altered appropriately in accordance with the variety of the thermal adhesive sheet 26, although usually, the thickness of the sheet is preferably within a range from 5 to 200 µm. More specifically, in those cases where the thermal adhesive sheet 26 is a sheet formed from EVA, then from the viewpoints of achieving lightweight properties and favorable electrical insulation properties and the like, the thickness of the EVA sheet is preferably within a range from 10 to 200 µm, more preferably from 50 to 150 µm, and most preferably from 80 to 120 µm.

Examples of materials that may be used as the base sheet 24 in the solar cell module back protective sheet 20 of the present invention include resin sheets and aluminum sheets.

Examples of resin sheets that may be used as the base sheet 24 include the types of resin sheets typically used as protective sheets for the back surfaces of solar cell modules. Specific examples of these resin sheets include sheets formed from polymers such as polyethylene, polypropylene, polystyrene, poly(methyl methacrylate), polytetrafluoroethylene, polyamide (Nylon 6, Nylon 66), polyacrylonitrile, polyvinyl chloride, polyethylene terephthalate (PET), polybutylene terephthalate (PBT), polyethylene naphthalate (PEN), polyoxymethylene, polycarbonate, polyphenylene oxide, polyester urethane, poly(m-phenylene isophthalamide) and poly(p-phenylene terephthalamide). Of these, from the viewpoints of achieving favorable levels of electrical insulation, heat resistance, chemical resistance and dimensional stability, sheets formed from polyethylene terephthalate (PET), polybutylene terephthalate (PBT) or polyethylene naphthalate (PEN) are preferred, and PET sheets are particularly desirable.
The PET sheet preferably exhibits good hydrolysis resistance, and it is known that a sheet containing minimal oligomers exhibits good resistance to hydrolysis. A specific example of a PET sheet that exhibits good hydrolysis resistance is Melinex 238 (a product name, manufactured by Teijin DuPont Films Ltd.).

The thickness of the resin sheet may be selected on the basis of the electrical insulation properties required by the solar cell system. Typically, the thickness of the resin sheet is preferably within a range from 10 to 300 µm. More specifically, if the resin sheet is a PET sheet, then from the viewpoints of lightening the weight while ensuring good electrical insulation properties, the thickness of the PET sheet is preferably within a range from 30 to 250 µm, more preferably from 40 to 200 µm, and still more preferably from 50 to 150 µm.

Further, the resin sheet may be subjected to a surface modification treatment in order to improve the weather resistance and moisture resistance and the like. For example, by vapor deposition of silica (SiO₂) aluminum (Al) and/or alumina (Al₂O₃) or the like on the surface of the PET sheet, the weather resistance and moisture resistance and the like of the solar cell module back protective sheet can be improved. The vapor deposition of silica, aluminum and/or alumina or the like may be performed either on both surfaces of the resin sheet, or on only one of the sheet surfaces.

When the base sheet 24 within the solar cell module back protective sheet 20 of the present invention is an aluminum sheet, the weather resistance and moisture and heat resistance of the back protective sheet can be improved significantly.

There are no particular limitations on the aluminum sheet used for the base sheet 24, provided the effects of the present invention are not impaired, but a sheet of an aluminum-iron alloy containing 0.7 to 5.0 mass% of iron is preferred, a sheet of an aluminum-iron alloy containing 1.0 to 2.0 mass% of iron is more preferred, and a sheet of an aluminum-iron alloy containing 1.2 to 1.7 mass% of iron is still more preferred. Specific examples include those alloys classified with the alloy number 8021 prescribed in JIS H4160. An example of such an aluminum-iron alloy produced in sheet form that can be used favorably in the present invention is PACAL21 (a product name) manufactured by Nippon Foil Mfg. Co., Ltd. Further, BESPA (a product name) manufactured by Sumikei Aluminum Foil Co., Ltd. can also be used favorably.

By using an aluminum-iron alloy sheet containing an amount of iron that satisfies the range described above, the water vapor barrier properties and lightweight properties of the solar cell module back protective sheet 20 can be improved compared with the case where a sheet of pure aluminum is used. It is thought that the reason for these improvements is that an aluminum-iron alloy sheet containing an amount of iron that satisfies the above range generally exhibits a degree of rolling workability that is superior to that of pure aluminum, and therefore even when a sheet having a thickness of 20 µm or less is produced, pinhole occurrence is minimal, meaning the circulation of gases through such pinholes is inhibited, and as a result, the water vapor barrier properties of the back protective sheet that uses the aluminum-iron alloy sheet can be enhanced. Further, because the aluminum-iron alloy exhibits superior rolling workability, the sheet can be worked to produce a thinner sheet than a pure aluminum sheet while still maintaining good water vapor barrier properties, thus enabling a reduction in the weight of the back protective sheet using the aluminum-iron alloy sheet.

The aluminum-iron alloy sheet may contain elements other than iron, provided the effects of the present invention are not impaired. Examples of these other elements include magnesium, manganese, copper, silicon, zinc and titanium. These elements are often unavoidably incorporated within the aluminum-iron alloy during production of the alloy, but it is thought that provided the amounts of these elements are small, the effects of the present invention are not impaired. Here, a "small amount" refers to those cases where the amount of each element is not more than 0.5 mass%, and preferably not more than 0.3 mass%.

There are no particular limitations on the thickness of the aluminum-iron alloy sheet, provided the thickness does not impair the effects of the present invention. However, from the viewpoints of lowering the frequency of pinhole occurrence (improving the water vapor barrier properties) and reducing the weight, the thickness of the aluminum-iron alloy sheet is preferably not more than 30 µm, more preferably not more than 20 µm, and most preferably within a range from 5 to 10 µm.

In the solar cell module back protective sheet 20 of the present invention, the method used for laminating the thermal adhesive sheet 26 to the base sheet 24 via the urethane-based adhesive layer 28 may involve forming the urethane-based adhesive layer 28 on the base sheet 24, and then using a lamination method to laminate the thermal adhesive sheet 26 thereon. Further, in order to further improve the adhesion, the surface of the base sheet 24 facing the urethane-based adhesive layer 28 may be subjected to a corona treatment and/or a chemical treatment.

The solar cell module back protective sheet 20 of the present embodiment has a structure in which the thermal adhesive sheet 26 is laminated to the base sheet 24 with the urethane-based adhesive layer 28 disposed therebetween, the thermal adhesive sheet 26 contains a pigment, and the urethane-based adhesive layer 28 contains a silane coupling agent, and as a result of an affinity improvement effect provided by the pigment and the silane coupling agent, the base sheet 24 and the thermal adhesive sheet 26 can be bonded together strongly. Accordingly, deterioration in the weather resistance, the durability and/or the moisture and heat resistance caused by peeling of the base sheet 24 can be prevented, and a solar cell module back protective sheet can be provided that retains favorable adhesion and continues to protect the solar cell module even after long periods of outdoor use.

In the back protective sheet 20 of the embodiment described above, a fluororesin layer (not shown in the figure) is preferably provided on the back surface of the base sheet 24, opposite the surface that contacts the urethane-based adhesive layer 28. By providing the fluororesin layer, the weather resistance of the solar cell module back protective sheet according to the present invention can be improved.
There are no particular limitations on the fluororesin layer, provided it does not impair the effects of the present invention. For example, the fluororesin layer may be a sheet that includes a fluorine-containing polymer, or a coating formed by applying a coating material that includes a fluorine-containing polymer. From the viewpoint of minimizing the thickness of the fluororesin layer so as to reduce the weight of the back protective sheet, the fluororesin layer is preferably a coating formed by applying a coating material that includes a fluorine-containing polymer.

Preferred examples of the above-mentioned sheet that includes a fluorine-containing polymer include sheets of a polymer that contains, as the main component, polyvinyl fluoride (PVF), ethylene chlorotrifluoroethylene (ECTFE) or ethylene tetrafluoroethylene (ETFE). Tedlar (a product name) manufactured by E. I. du Pont de Nemours and Company can be used as the polymer containing PVF as the main component. Further, Halar (a product name) manufactured by Solvay Solexis Company can be used as the polymer containing ECTFE as the main component. Moreover, Fluon (a product name) manufactured by Asahi Glass Co., Ltd. can be used as the polymer containing ETFE as the main component.
From the viewpoints of weather resistance and weight reduction, the thickness of the sheet that includes a fluorine-containing polymer is preferably within a range from 5 to 200 µm, more preferably from 10 to 100 µm, and most preferably from 10 to 50 µm.

There are no particular limitations on the coating material that includes a fluorine-containing polymer, provided the material can be dissolved or dispersed within a solvent and is able to be applied to form a coating.
There are no particular limitations on the fluorine-containing polymers that may be included within the coating material, provided the polymer contains fluorine and does not impair the effects of the present invention, but a polymer that dissolves in the above-mentioned coating material solvent (an organic solvent or water) and is capable of cross-linking is preferred. Preferred examples of the fluorine-containing polymer include polymers containing chlorotrifluoroethylene (CTFE) as the main component, such as LUMIFLON (a product name) manufactured by Asahi Glass Co., Ltd., CEFRAL COAT (a product name) manufactured by Central Glass Co., Ltd., and FLUONATE (a product name) manufactured by DIC Corporation, polymers containing tetrafluoroethylene (TFE) as the main component, such as ZEFFLE (a product name) manufactured by Daikin Industries, Ltd., polymers having fluoroalkyl groups such as Zonyl (a product name) manufactured by E. I. du Pont de Nemours and Company and Unidyne (a product name) manufactured by Daikin Industries, Ltd., and polymers containing fluoroalkyl units as a major component. Of these, from the viewpoints of weather resistance and pigment dispersibility and the like, polymers containing CTFE as the main component and polymers containing TFE as the main component are preferable, and of such polymers, the above-mentioned LUMIFLON (a product name) and ZEFFLE (a product name) are the most desirable.

The above-mentioned LUMIFLON (a product name) is the name used for a series of amorphous polymers containing CTFE and a number of specific alkyl vinyl ethers and hydroxyalkyl vinyl ethers as the main structural units. Polymers such as LUMIFLON (a product name) that include hydroxyalkyl vinyl ethers as monomer units are particularly desirable as they exhibit superior levels of solvent solubility, cross-linking reactivity, substrate adhesion, pigment dispersibility, hardness and flexibility.
The above-mentioned ZEFFLE (a product name) is the name used for a series of copolymers of TFE and a hydrocarbon olefin that is soluble in organic solvents. Of these copolymers, those that employ a hydrocarbon olefin having a highly reactive hydroxyl group are particularly desirable as they exhibit superior levels of solvent solubility, cross-linking reactivity, substrate adhesion and pigment dispersibility.

Further, examples of fluorine-containing polymers that may be included within the coating material include fluoroolefin polymers that contain curable functional groups, and specific examples include copolymers formed from TFE, isobutylene, vinylidene fluoride (VdF), hydroxybutyl vinyl ether and other monomers, and copolymers formed from TFE, VdF, hydroxybutyl vinyl ether and other monomers.

Furthermore, examples of copolymerizable monomers within the fluorine-containing polymer that may be included within the above-mentioned coating material include vinyl esters of carboxylic acids such as vinyl acetate, vinyl propionate, vinyl butyrate, vinyl isobutyrate, vinyl pivalate, vinyl caprate, vinyl versatate, vinyl laurate, vinyl stearate, vinyl cyclohexylcarboxylate and vinyl benzoate, and alkyl vinyl ethers such as methyl vinyl ether, ethyl vinyl ether, butyl vinyl ether and cyclohexyl vinyl ether.

Besides the fluorine-containing polymer described above, the coating material may also include one or more cross-linking agents, catalysts and solvents, and if necessary, may also include inorganic compounds such as pigments and fillers.

There are no particular limitations on the solvent included within the coating material provided it does not impair the effects of the present invention, and examples of solvents that can be used favorably include solvents containing one or more of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate and n-butyl alcohol. Of the various possibilities, from the viewpoints of achieving good solubility of the components within the coating material, a solvent containing one or more of MEK and MIBK is particularly preferred.

There are no particular limitations on the pigments and fillers that may be included in the coating material, provided they do not impair the effects of the present invention. Examples include titanium dioxide, carbon black and silica. More specific examples of preferred materials include Ti-Pure R105 (a product name, manufactured by E. I. du Pont de Nemours and Company), which is a rutile titanium dioxide that has been coated and surface-treated to impart durability, and CAB-O-SIL TS-720 (a product name, manufactured by Cabot Corporation), which is a hydrophobic silica in which the hydroxyl groups at the silica surface have been modified via a dimethylsilicone surface treatment.

In order to improve the weather resistance and abrasion resistance, the coating is preferably cured using a cross-linking agent. There are no particular limitations on this cross-linking agent provided it does not impair the effects of the present invention, and examples of cross-linking agents that can be used favorably include metal chelates, silanes, isocyanates, and melamines. If consideration is given to use of the solar cell module back protective sheet for 30 years or more in an outdoor environment, then from the viewpoint of weather resistance, an aliphatic isocyanate is preferred as the cross-linking agent.

There are no particular limitations on the composition of the coating material, provided it does not impair the effects of the present invention, and one example of a coating material composition based on the above-mentioned LUMIFLON is a composition prepared by mixing LUMIFLON (a product name), a pigment, a cross-linking agent, a solvent and a catalyst. In terms of the compositional ratio, based on a value of 100 mass% for the overall coating material, the proportion of LUMIFLON (a product name) is preferably within a range from 3 to 80 mass%, and more preferably from 10 to 40 mass%, the proportion of the pigment is preferably within a range from 5 to 60 mass%, and more preferably from 10 to 30 mass%, and the proportion of the organic solvent is preferably within a range from 20 to 80 mass%, and more preferably from 30 to 70 mass%.
One example of the organic solvent is a mixed solvent of MEK, xylene and cyclohexanone. Further, examples of the catalyst include dibutyltin dilaurate and dioctyltin dilaurate, which are used for promoting the cross-linking between the LUMIFLON (a product name) and the isocyanate within the organic solvent.

Conventional methods may be used as the method of applying the coating material to the opposite surface of the base sheet 24 from the surface that contacts the urethane-based adhesive layer 28, and for example, the coating material may be applied using a rod coater so as to achieve a desired thickness.
There are no particular limitations on the thickness of the fluororesin layer formed by curing the coating material, and for example, a thickness of 5 µm or greater is suitable. From the viewpoints of achieving favorable water vapor barrier properties, weather resistance and lightweight properties, the thickness of the fluororesin layer is preferably within a range from 5 to 50 µm, more preferably from 8 to 40 µm, and still more preferably from 10 to 30 µm.
Although the temperature used during the process for drying the applied coating material may be any temperature that does not impair the effects of the present invention, from the viewpoints of accelerating the cross-linking and reducing thermal deformation of the base sheet 24, the temperature is preferably within a range from 50 to 130°C.

The protective sheet for the back surface of a solar cell module according to the present invention may be combined with conventional materials used in the production of solar cell modules to produce a solar cell module.
As illustrated in FIG. 2, a solar cell module of the present invention includes solar cell 104 composed of crystalline silicon or amorphous silicon or the like, an encapsulant (filler layer) 103 formed from an electrical insulator that encapsulates the solar cell 104, a surface protective sheet (front sheet) 101 that is laminated to the front surface of the encapsulant 103, and a back protective sheet (back sheet) 102 that is laminated to the back surface of the encapsulant 103.
A resin containing, as the main component, a transparent resin such as a vinyl acetate-ethylene copolymer (EVA), polyvinyl butyral, silicone resin, epoxy resin, fluorinated polyimide resin, acrylic resin or polyester resin can be used as the encapsulant 103. The encapsulant 103 may employ either a single resin or a combination of two or more different resins.

By using the solar cell module back protective sheet 20 according to the present invention as the back protective sheet 102 illustrated in FIG. 2, and laminating the protective sheet to the encapsulated surface formed from theencapsulant 103 that encapsulates the solar cell 104, the solar cell 104 and the encapsulant 103 inside the solar cell module can be protected from heavy rain, moisture, dust, and mechanical impacts and the like, and the interior of the solar cell module can be maintained in a sealed state that completely blocks out the external environment.
In those cases where the solar cell module back protective sheet of the present invention is laminated to the above-mentioned encapsulated surface, the thermal adhesive sheet of the solar cell module back protective sheet is laminated to the encapsulated surface. A conventional method may be used for the lamination.

The above embodiment described the example of a solar cell module back protective sheet prepared by laminating one layer of each of the base sheet 24, the urethane-based adhesive layer 28 and the thermal adhesive sheet 26, but the solar cell module back protective sheet of the present invention is not limited to this particular configuration. The solar cell module back protective sheet of the present invention may also have a structure prepared by laminating a plurality of base sheets, urethane-based adhesive layers and/or fluororesin layers.

### EXAMPLES

The present invention is described below in further detail using a series of examples, although the present invention is in no way limited by the examples presented below.

### (Formation of thermal adhesive sheet 1)

100 parts by weight of Everflex V5961 (an ethylene-vinyl acetate copolymer manufactured by DuPont-Mitsui Polychemicals Co., Ltd., ethylene : vinyl acetate = 91:9) and 6.0 parts by weight of titanium dioxide GTR-300 (manufactured by Sakai Chemical Industry Co., Ltd.) as a pigment were mixed together, and the resulting mixture was subjected to melt extrusion using a T-die film casting apparatus Labo Plastomill (manufactured by Toyo Seiki Seisaku-sho, Ltd.) under conditions including a cylinder temperature of 220°C and a T-die temperature of 220°C, so as to form a film with a thickness of 100 µm and a width of 300 mm, thus completing formation of a thermal adhesive sheet 1.

### (Formation of thermal adhesive sheet 2)

100 parts by weight of Everflex V5961 (an ethylene-vinyl acetate copolymer manufactured by DuPont-Mitsui Polychemicals Co., Ltd., ethylene : vinyl acetate = 91:9) and 1.5 parts by weight of carbon black MA230 (manufactured by Mitsui Chemical Corporation) as a pigment were mixed together, and the resulting mixture was subjected to melt extrusion using a T-die film casting apparatus Labo Plastomill (manufactured by Toyo Seiki Seisaku-sho, Ltd.) under conditions including a cylinder temperature of 220°C and a T-die temperature of 220°C, so as to form a film with a thickness of 100 µm and a width of 300 mm, thus completing formation of a thermal adhesive sheet 2.

### (Formation of thermal adhesive sheet 3)

Everflex V5961 (an ethylene-vinyl acetate copolymer manufactured by DuPont-Mitsui Polychemicals Co., Ltd., ethylene : vinyl acetate = 91:9) was subjected to melt extrusion using a T-die film casting apparatus Labo Plastomill (manufactured by Toyo Seiki Seisaku-sho, Ltd.) under conditions including a cylinder temperature of 220°C and a T-die temperature of 220°C, so as to form a film with a thickness of 100 µm and a width of 300 mm, thus completing formation of a thermal adhesive sheet 3 that contained no pigment.

### Example 1

To a mixture containing 100 parts by weight of Takelac A-515 (a polyesterpolyol manufactured by Mitsui Chemical Corporation, solid fraction: 60%) and 11.1 parts by weight of Takenate A-50 (xylylene diisocyanate, manufactured by Mitsui Chemical Corporation, solid fraction: 75%) was added 2.2 parts by weight of 3-glycidoxypropyltrimethoxysilane as a silane coupling agent, and 278.3 parts by weight of ethyl acetate was then added and mixed to complete preparation of a urethane-based adhesive.
Subsequently, using a PET film of Melinex S (manufactured by Teijin DuPont Films Ltd., thickness: 125 µm) as the base sheet, a rod coater was used to apply the above urethane-based adhesive to one surface of the base sheet, in an amount sufficient to produce a dried coating thickness of 5 µm, and the applied coating was then dried at 80°C for one minute to form a urethane-based adhesive layer. The above-mentioned thermal adhesive sheet 1 was then laminated to the urethane-based adhesive layer at ambient temperature, and the resulting structure was left to stand for 7 days in an atmosphere at 23°C and 50% RH, thus yielding a solar cell module back protective sheet.
The adhesive strength of the prepared solar cell module back protective sheet was evaluated under accelerated test conditions using the method described below. The results are shown in Table 1.

### (Accelerated test)

The prepared solar cell module back protective sheet was cut to A4 size, and left to stand in an atmosphere at 85°C and 85% RH for a period of 500 hours, 1,000 hours, 1,500 hours and 2,000 hours.

### (Adhesive strength evaluation)

The peel adhesive strength was evaluated using the T-peel test prescribed in ISO 11339. The solar cell module back protective sheet was cut into a strip having a width of 25 mm and a length of 150 mm, and the adhesive-bonded base sheet and thermal adhesive sheet were secured respectively to the upper and lower grips of a tensile tester (Autograph AG-50kNX, manufactured by Shimadzu Corporation), and the peel adhesive strength (N/25 mm) was measured in an environment at 23°C and 50% RH when peeling was performed at a peel speed of 300 mm/minute. A larger numerical result indicates greater adhesive strength.

### Examples 2 to 6, and Comparative examples 1 and 2

To a mixture containing 100 parts by weight of Takelac A-515 (a polyesterpolyol manufactured by Mitsui Chemical Corporation, solid fraction: 60%) and 11.1 parts by weight of Takenate A-50 (xylylene diisocyanate, manufactured by Mitsui Chemical Corporation, solid fraction: 75%) was added 2.2 parts by weight of a silane coupling agent shown in Table 1, and 278.3 parts by weight of ethyl acetate was then added and mixed to complete preparation of a urethane-based adhesive.
Subsequently, using a PET film of Melinex S (manufactured by Teijin DuPont Films Ltd., thickness: 125 µm) as the base sheet, a rod coater was used to apply the prepared urethane-based adhesive to one surface of the base sheet, in an amount sufficient to produce a dried coating thickness of 5 µm, and the applied coating was then dried at 80°C for one minute to form a urethane-based adhesive layer. The thermal adhesive sheet shown in Table 1 was then laminated to the urethane-based adhesive layer at ambient temperature, and the resulting structure was left to stand for 7 days in an atmosphere at 23°C and 50% RH, thus yielding a solar cell module back protective sheet.
The adhesive strength of each of the prepared solar cell module back protective sheets was evaluated under accelerated test conditions using the same method as that described for Example 1. The results are shown in Table 1.

**[Table 1]**

| | Silane coupling agent | Thermal adhesive sheet | Adhesive strength (N/25 mm) | | | | |
|---|---|---|---|---|---|---|---|
| | | | Accelerated test time (hours) | | | | |
| | | | 0 h | 500 h | 1,000 h | 1,500 h | 2,000 h |
| Example 1 | A-1 | B-1 | 35.2 | 34.9 | 32.0 | 22.0 | 15.3 |
| Example 2 | A-2 | B-1 | 38.2 | 34.2 | 27.0 | 21.5 | 16.7 |
| Example 3 | A-3 | B-1 | 37.8 | 34.2 | 27.7 | 21.5 | 17.2 |
| Example 4 | A-4 | B-1 | 32.1 | 32.0 | 25.3 | 21.0 | 17.0 |
| Example 5 | A-5 | B-1 | 37.3 | 35.4 | 12.5 | 11.8 | 10.1 |
| Example 6 | A-1 | B-2 | 35.9 | 35.4 | 28.0 | 21.5 | 15.5 |
| Comparative example 1 | A-1 | B-3 | 6.7 | 6.6 | 6.0 | 5.1 | 4.8 |
| Comparative example 2 | none | B-1 | 32.2 | 27.2 | 11.6 | 7.5 | 6.8 |

The symbols used in Table 1 refer to the items listed below.
A-1: 3-glycidoxypropyltrimethoxysilane
A-2: phenyltrimethoxysilane
A-3: tetraethoxysilane
A-4: 3-acetoxypropyltrimethoxysilane
A-5: 3-aminopropyltrimethoxysilane
B-1: the above-mentioned thermal adhesive sheet 1
B-2: the above-mentioned thermal adhesive sheet 2
B-3: the above-mentioned thermal adhesive sheet 3

The results in Table 1 confirmed that, compared with Comparative Examples 1 and 2, Examples 1 to 6, which represent solar cell module back protective sheets according to the present invention, exhibited superior adhesive strength even under accelerated test conditions of high temperature and high humidity. Based on these results it is evident that the solar cell module back protective sheet of the present invention exhibits excellent moisture and heat resistance and excellent adhesion.

### Examples 7 to 11 and Comparative example 3

To a mixture containing 100 parts by weight of Takelac A-515 (a polyesterpolyol manufactured by Mitsui Chemical Corporation, solid fraction: 60%) and 11.1 parts by weight of Takenate A-50 (xylylene diisocyanate, manufactured by Mitsui Chemical Corporation, solid fraction: 75%) was added 2.2 parts by weight of a silane coupling agent shown in Table 2, and 278.3 parts by weight of ethyl acetate was then added and mixed to complete preparation of a urethane-based adhesive.
Subsequently, using a PET film of Melinex 238 which includes little oligomer (manufactured by Teijin DuPont Films Ltd., thickness: 125 µm) as the base sheet, a rod coater was used to apply the prepared urethane-based adhesive to one surface of the base sheet, in an amount sufficient to produce a dried coating thickness of 5 µm, and the applied coating was then dried at 80°C for one minute to form a urethane-based adhesive layer. The above-mentioned thermal adhesive sheet 1 was then laminated to the urethane-based adhesive layer at ambient temperature, and the resulting structure was left to stand for 7 days in an atmosphere at 23°C and 50% RH, thus yielding a solar cell module back protective sheet.
Each of the prepared solar cell module back protective sheets was stored under conditions at 121°C, 100% RH and 2 atm., and the adhesive strength following storage for a period of 24 hours, 48 hours and 96 hours was measured using the same method as that described for Example 1. The results are shown in Table 2.

**[Table 2]**

| | Silane coupling agent | Adhesive strength (N/25 mm) | | | |
|---|---|---|---|---|---|
| | | Accelerated test time (hours) | | | |
| | | 0h | 24h | 48h | 96h |
| Example 7 | A-1 | 12.6 | 12.1 | 35.2 | 34.8 |
| Example 8 | A-2 | 17.3 | 17.1 | 17.5 | 14.1 |
| Example 9 | A-3 | 12.8 | 12.8 | 37.0 | 37.1 |
| Example 10 | A-4 | 12.1 | 12.2 | 31.8 | 32.1 |
| Example 11 | A-5 | 12.2 | 11.8 | 36.8 | 37.3 |
| Comparative example 3 | none | 12.3 | 12.5 | 11.6 | 10.8 |

The symbols used in Table 2 refer to the items listed below.
A-1: 3-glycidoxypropyltrimethoxysilane
A-2: phenyltrimethoxysilane
A-3: tetraethoxysilane
A-4: 3-acetoxypropyltrimethoxysilane
A-5: 3-aminopropyltrimethoxysilane

The results in Table 2 confirmed that, compared with Comparative Example 3, Examples 7 to 11, which represent solar cell module back protective sheets according to the present invention, exhibited superior adhesive strength even under accelerated test conditions of high temperature and high humidity. Based on these results it is evident that the solar cell module back protective sheet of the present invention exhibits excellent moisture and heat resistance and excellent adhesion.

### INDUSTRIAL APPLICABILITY

In the present invention, a thermal adhesive sheet containing a pigment is laminated to a base sheet with a urethane-based adhesive layer containing a silane coupling agent disposed therebetween, and as a result, the base sheet and the thermal adhesive sheet can be bonded together with good adhesion, enabling the preparation of a solar cell module back protective sheet that exhibits extremely superior resistance to heat and moisture. Accordingly, a solar cell module back protective sheet can be provided that exhibits excellent barrier properties as a back protective sheet and is capable of preventing electrical leakage or corrosion of the electrical circuits inside the solar cell module. By installing this back protective sheet on the back surface of a solar cell module, the solar cell module can be used in a stable manner for long periods.

### DESCRIPTION OF THE REFERENCE SIGNS

20: Solar cell module back protective sheet
24: Base sheet
26: Thermal adhesive sheet
28: Urethane-based adhesive layer
100: Solar cell module
101: Front sheet (front surface protective sheet)
102: Back sheet (back surface protective sheet)
103: Encapsulant
104: Solar cell

## Claims

1. A protective sheet for a back surface of a solar cell module, the protective sheet prepared by laminating a thermal adhesive sheet to at least one surface of a base sheet with a urethane-based adhesive layer disposed therebetween, wherein
the thermal adhesive sheet comprises a pigment, and the urethane-based adhesive layer comprises a silane coupling agent.

2. The protective sheet for a back surface of a solar cell module according to claim 1, wherein the pigment incorporated in the thermal adhesive sheet is an inorganic pigment or a carbon black.

3. A solar cell module, comprising the protective sheet for a back surface of a solar cell module according to claim 1 or 2.
